# EUROPEAN PATENT APPLICATION

(11) **EP 2 267 173 A1**
(43) Date of publication of application: **29.12.2010**
(21) Application number: 09729125.6
(22) Date of filing: 30.03.2009
(51) Int. Cl.: C22C 9/06, C22F 1/08, H01L 23/48, C22F 1/00

(54) **COPPER ALLOY MATERIAL FOR ELECTRIC AND ELECTRONIC APPARATUSES, AND ELECTRIC AND ELECTRONIC COMPONENTS**

(30) Priority: 31.03.2008 JP 2008092314
(71) Applicant: The Furukawa Electric Co., Ltd., Chiyoda-ku Tokyo 100-8322 (JP)
(72) Inventor: SATO, Koji, Tokyo 100-8322 (JP); HIROSE, Kiyoshige, Tokyo 100-8322 (JP); KANEKO, Hiroshi, Tokyo 100-8322 (JP)
(74) Representative: Forstmeyer, Dietmar
(86) International application number: PCT/JP2009/056575
(87) International publication number: WO 2009/123158

(57) **Abstract**

A copper alloy material for an electrical/electronic equipment, containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, and Zn 0.2 to 1.5 mass%, with the balance of Cu and inevitable impurities, wherein when a test piece with thickness t of 0.20 mm and width w of 2.0 mm is subjected to 180°-bending with bending radius R (mm), a value of the minimum bending radius R causing no cracks is 0 mm to 0.1 mm; and, an electrical/electronic part obtained by working the same.

## Description

### TECHNICAL FIELD

The present invention relates to a copper alloy material for electrical/electronic equipments, and to an electrical/electronic part.

### BACKGROUND ART

Parts of electrical/electronic equipments, for example, spring contact materials of connectors, are required to have properties, for example, mechanical strength, stress relaxation resistance, electrical conductivity, bending property, heat resistance, plating adhesiveness, and migration property. Conventionally, phosphor bronze has been used in many cases, but phosphor bronze is not completely satisfactory in the properties described above. Thus, beryllium copper, which is higher in mechanical strength and excellent in stress relaxation resistance, has become used widely.
However, beryllium copper is very expensive, and metal beryllium is regarded as a substance of concern (SoC). Thus, Corson alloy (Cu-Ni-Si-based alloy), in which nickel (Ni) and silicon (Si) are added to copper, has been attracted attention as an alloy that will substitute for those materials.
Corson alloy is a precipitation-hardening-type alloy, which is strengthened by dispersing and precipitating fine particles of Ni₂Si intermetallic compounds in Cu, and there have been reports on the attempts to enhance mechanical strength and electrical conductivity by defining the amounts of addition of Ni and Si or the ratio of Ni/Si (see Patent Literatures 1 and 2). Hitherto, it is considered, in regard to the Corson alloy, that the ratio of the contents of Ni and Si in terms of percentage by mass, that is, the value of Ni (% by mass)/Si (% by mass) (hereinafter, indicated as Ni/Si), is preferably within the range around 4.2, which is a stoichiometric ratio of the Ni₂Si compound that mainly contributes to strengthening. Thus, the Ni/Si is within the range of Ni/Si of 3 to 7 in Patent Literature 1, and is within the range of Ni/Si of 3.5 to 5.5 in Patent Literature 2. Further, Patent Literature 1 describes, with concerns about a possible lowering of the electrical conductivity caused by solid solution of Si, that in order to reduce the amount of the solid solution of Si as less as possible, the amount of Ni is preferably in slight excess compared to the Ni₂Si composition, and that Ni/Si = 4.5 is most preferred. Patent Literature 2 also describes that the Ni/Si is preferably close to 4.2, which is the stoichiometric ratio of Ni₂Si, with concerns about a possible lowering of the electrical conductivity due to an increase in the amounts of solid solutions of Ni and Si when the value of Ni/Si is away from 4.2.
{Patent Literature 1} JP-A-2001-181759 ("JP-A" means unexamined published Japanese patent application)
{Patent Literature 2} JP-A-2006-233314

### DISCLOSURE OF INVENTION

### TECHNICAL PROBLEM

However, as shown in Patent Literatures 1 and 2, the Ni/Si in the conventional alloys has been such that, while the stoichiometric ratio of Ni₂Si, or a value corresponding to an excess amount of Ni compared to the stoichiometric ratio of Ni₂Si, is considered preferable, the definition of the range of the ratio is broad and ambiguous. Further, investigations have been extensively made to maintain the balance between mechanical strength and electrical conductivity, but sufficient investigations have not been made on the conditions of obtaining high mechanical strength and favorable bending property.
Thus, the present invention is contemplated for providing a copper alloy material for electrical/electronic equipments, having a high mechanical strength and a remarkably favorable bending property, and an electrical/electronic part utilizing the same.

### SOLUTION TO PROBLEM

The inventors of the present invention have found a region to make grains finer and to enhance aging strength, at a side of Si in excess of the stoichiometric ratio of Ni₂Si even in the conventional Ni/Si range. The present invention has attained based on the finding above.
According to the present invention, there is provided the following means:
(1) A copper alloy material for an electrical/electronic equipment, containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, and Zn 0.2 to 1.5 mass%, with the balance of Cu and inevitable impurities, wherein when a test piece with thickness t of 0.20 mm and width w of 2.0 mm is subjected to 180°-bending with bending radius R (mm), a value of the minimum bending radius R causing no cracks is 0 mm to 0.1 mm;
(2) A copper alloy material for an electrical/electronic equipment, containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, Zn 0.2 to 1.5 mass%, and one or more selected from the group consisting of Ag, Co, and Cr in a sum total of 0.005 to 2.0 mass%, with the balance of Cu and inevitable impurities, wherein when a test piece with thickness t of 0.20 mm and width w of 2.0 mm is subjected to 180°-bending with bending radius R (mm), a value of the minimum bending radius R causing no cracks is 0 mm to 0.1 mm;
(3) The copper alloy material for an electrical/electronic equipment as described in item (1) or (2), which is produced by subjecting a cast ingot to a hot rolling, a dough (cold) rolling, and a solution treatment, followed by an intermediate (cold) rolling with rolling ratio of 5 to 50%, an aging at 400 to 600°C for 0.5 to 12 hours, a finish (cold) rolling with rolling ratio of 30% or less, and a low-temperature annealing, in this order;
(4) The copper alloy material for an electrical/electronic equipment as described in item (1) or (2), which is produced by subjecting a cast ingot to a hot rolling, a dough (cold) rolling, and a solution treatment, followed by an aging at 300 to 400°C for 0.5 to 8 hours, a further aging at 425 to 600°C for 0.5 to 12 hours, a finish (cold) rolling, and a low-temperature annealing, in this order;
(5) The copper alloy material for an electrical/electronic equipment as described in item (1) or (2), which is produced by subjecting a cast ingot to a hot rolling, a dough (cold) rolling, and a solution treatment, followed by an intermediate (cold) rolling with rolling ratio of 5 to 50%, an aging at 300 to 400°C for 0.5 to 8 hours, a further aging at 425 to 600°C for 0.5 to 12 hours, a finish (cold) rolling with rolling ratio of 30% or less, and a low-temperature annealing, in this order;
(6) An electrical/electronic part obtained by working a copper alloy material for an electrical/electronic equipment, with the copper alloy material containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, and Zn 0.2 to 1.5 mass%, with the balance of Cu and inevitable impurities, wherein when a test piece of the copper alloy material with thickness t of 0.20 mm and width w of 2.0 mm is subjected to 180°-bending with bending radius R (mm), a value of the minimum bending radius R causing no cracks is 0 mm to 0.1 mm; and
(7) An electrical/electronic part obtained by working a copper alloy material for an electrical/electronic equipment, with the copper alloy material containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, Zn 0.2 to 1.5 mass%, and one or more selected from the group consisting of Ag, Co, and Cr in a sum total of 0.005 to 2.0 mass%, with the balance of Cu and inevitable impurities, wherein when a test piece of the copper alloy material with thickness t of 0.20 mm and width w of 2.0 mm is subjected to 180°-bending with bending radius R (mm), a value of the minimum bending radius R causing no cracks is 0 mm to 0.1 mm.

### ADVANTAGEOUS EFFECTS OF INVENTION

The copper alloy material of the present invention for electrical/electronic equipments has a higher electrical conductivity than conventional phosphor bronze, has an electrical conductivity at the same level as or higher than beryllium copper (C17200, C17530), and thus has a sufficient electrical conductivity for the use in connectors. The copper alloy material also has a high mechanical strength and has a remarkably favorable bending property. Further, since the electrical/electronic part of the present invention is obtained by working the copper alloy material for electrical/electronic equipments, the part has a high mechanical strength and also has a remarkably favorable bending property required for parts of the connector use.
Other and further features and advantages of the invention will appear more fully from the following description.

### BEST MODE FOR CARRYING OUT THE INVENTION

In the present invention, by setting the content of Ni to not less than 2.0 mass% and less than 3.3 mass%, the resultant copper alloy material can have a sufficient electrical conductivity, a high mechanical strength, and a remarkably favorable bending property. When the content of Ni is less than the lower limit value, a sufficient strength cannot be obtained. Further, when the content of Ni exceeds the upper limit value, the thus-obtained copper alloy material has a high strength but tends to have a low electrical conductivity.

Further, in the present invention, the Ni/Si (mass ratio of the contents) is defined to be within the range of 2.8 to 3.8. By setting the ratio within this range, since precipitation of Ni₃Si₂ can be expected in addition to the precipitation of Ni₂Si and the precipitation densities of Ni₂Si and Ni₃Si₂ are increased, the tensile strength is enhanced upon aging. Further, since the grain size upon the solution treatment can be controlled to be smaller as a result of an increase in the amount of solid solution of Si, the grains also act satisfactorily in the bending property. When the ratio is greater than the upper limit value, the required effect of enhancing the strength upon the aging cannot be obtained. On the other hand, when the ratio is less than the lower limit value, the required effect of enhancing the strength upon the aging cannot be obtained, and the electrical conductivity is lowered by the amount of solid solution of Si is more noticeable than the effect of controlling the grain size, which exerts an adverse influence. A more preferable range of the Ni/Si is around 3.3, which is 3.0 to 3.5. When the ratio is in this range, a material can be obtained which is favorable in the balanced of the tensile strength, the electrical conductivity, and the bending property.

Mg improves the stress relaxation resistance, but its content is defined to 0.01 to 0.2 mass%, since when the content is less than 0.01 mass%, an improvement in the stress relaxation resistance cannot be seen, and when the content is greater than 0.2 mass%, Mg in such a too high content gives adverse affects on the bending property. The content of Mg is preferably 0.05 to 0.15 mass%.

Sn is interrelated with Mg, thereby to improve the stress relaxation resistance further. The content of Sn is defined to 0.05 to 1.5 mass%, because when the content is less than 0.05 mass%, the effects are not sufficiently obtained, and when the content is greater than 1.5 mass%, the electrical conductivity is lowered. The content of Sn is preferably 0.1 to 0.7 mass%.

Zn slightly improves the bending property. Preferably, when the amount of Zn is defined to 0.2 to 1.5 mass%, the bending property can be obtained at a level that is free of problem for practical use even if Mg is added in an amount up to 0.2 mass% at the maximum. In addition to that, Zn improves the adhesiveness of Sn plating or solder plating, or the migration property. When the amount of Zn is greater than 1.5 mass%, the electrical conductivity is lowered. The content of Zn is more preferably 0.3 to 1.0 mass%.

The copper alloy material of the present invention may also contain one or two or more of Ag, Co, and Cr in 0.005 to 2.0 mass% in a total of those, in addition to the elements described above.
Ag improves the heat resistance and enhances the strength, and also inhibits coarsening of the grains, thereby to improve the bending property. When the amount of Ag is less than 0.005 mass%, the effects are not sufficiently obtained, and even if Ag is added in an amount greater than 0.3 mass%, the production cost increases without any adverse affects on the properties. From those points of view, the content of Ag is defined to 0.005 to 0.3 mass%.
Similarly to Ni, Co forms a compound with Si, to enhance the strength. When the content of Co is less than 0.05 mass%, the effects are not sufficiently obtained, and when the content is greater than 2.0 mass%, crystallization and precipitation products which do not contribute to the strength are present even after the solution treatment, so that the bending property is deteriorated.
Cr precipitates as a second phase with Ni and/or Si, and is effective in the control of the grain size. When the content is less than 0.05 mass%, the effects are not sufficiently obtained, and when the content is greater than 1.0 mass%, the bending property is deteriorated.
In the case of adding two or more of Ag, Co, and Cr, the contents are determined within the range of 0.005 to 2.0 mass%, according to the required properties.

The copper alloy material for electrical/electronic equipments of the present invention is preferably produced by the steps of: casting, hot rolling, dough rolling, and solution treatment, followed by intermediate rolling, aging, finish rolling, and low-temperature annealing.
The shape of the copper alloy material for electrical/electronic equipments of the present invention is not particularly limited, and examples include sheet (plate), strip, wire, rod, and foil.

A preferred method of producing the copper alloy material of the present invention is explained in detail below. In the following, a method of producing a copper alloy sheet or a copper alloy strip is described in detail as a representative example.
In the present invention, the casting is conducted by a usual DC (direct chill casting) method, or the like. It is preferable that, immediately after conducting a homogenization treatment of the resultant ingot at a temperature of 850°C to 1,000°C for 0.5 to 12 hours, the hot rolling is conducted at a temperature of 700°C to 950°C, followed by water cooling to prevent precipitation in the cooling. After the hot rolling, an oxide layer is face-milled, followed by the cold rolling. Hereinafter, this cold rolling is referred to as dough rolling. The dough rolling is conducted to a sheet thickness, to give a given working ratio in the intermediate rolling and the finish rolling, respectively.

It is preferable that the solution treatment is conducted at a material's substantial temperature of 700°C to 880°C, followed by maintaining for approximately 3 to 6 seconds, and cooling with a cooling speed of 15°C/sec or more (more preferably 30°C/sec or more) to prevent precipitation. When the solution treatment temperature is lower than 700°C, such problems occur that it is not possible to obtain a sound recrystallized structure, to affect as negatively to the bending property, and that the amounts of the solid solution of Ni and Si become insufficient, to result in an insufficient precipitated amount of the Ni-Si-based precipitation upon the aging, thereby to fail to obtain a sufficient proof stress. When the solution treatment temperature is higher than 880°C, coarsening of the recrystallized grains occur, to cause lowering of the strength, exhibition of an anisotropy, and deterioration of the bending property.

As the intermediate rolling, a cold-rolling is conducted, to enhance the tensile strength and the proof stress upon the aging. Dislocations are introduced into the matrix of the copper alloy upon the intermediate rolling, but a part of the dislocations function as the heterogeneous nucleation sites of the Ni-Si-based compound in the subsequent aging step, aiding the formation of the compound at a high density with a fine size, and enhancing further the effect of increasing the precipitation density owing to the controlling of the Ni/Si. It is preferable to introduce the intermediate rolling, to enhance the aging strength as well; but if the rolling ratio is too high, the effect of enhancing the aging strength is saturated and the bending property is deteriorated. Thus, it is preferable to conduct the intermediate rolling within the range of rolling ratio 5 to 50%.

The aging makes it possible to precipitate and disperse the Ni₂Si and Ni₃Si₂ compounds uniformly into the copper matrix, to enhance the strength and improve the electrical conductivity. It is preferable to conduct the aging with a batch-type furnace, to maintain at a material's substantial temperature of 400°C to 600°C for 0.5 to 12 hours. When the substantial temperature is lower than 400°C, a quite longer period of time is necessary to obtain a sufficient precipitation amount of the Ni-Si-based compound, or the proof stress and the electrical conductivity result in insufficient. When the substantial temperature is higher than 600°C, the Ni-Si-based compound becomes coarsened, to fail to obtain the proof stress sufficiently.
Furthermore, when the aging is carried out in two stages of: aging at a substantial temperature of the material of 300 to 400°C for 0.5 to 8 hours, and then aging at a substantial temperature of 425 to 600°C for 0.5 to 12 hours, it is possible to increase the precipitation density of the Ni-Si-based compound and to further enhance the strength and improve the bending property. When this two-stage aging is carried out, the intermediate rolling may not be carried out; but by conducting the intermediate rolling, the strength can be further enhanced.

As the finish rolling, a cold-rolling is conducted to enhance the proof stress. When the proof stress after the aging is sufficient, it may be possible to omit the finish rolling and the subsequent low-temperature annealing. When the rolling ratio in the finish rolling is too high, the bending property is deteriorated and the stress relaxation resistance is deteriorated. Thus, the finish rolling is preferably conducted with a rolling ratio of 30% or less.

The low-temperature annealing is conducted to recover an elongation, the bending property, and a spring limit value, while maintaining the strength in a certain degree. When the substantial temperature at the low-temperature annealing is too high, recrystallization occurs, to cause lowering of the proof stress. Thus, it is preferable to conduct the annealing at the substantial temperature of 300 to 600°C for a short period of time of 5 to 60 seconds. When the substantial temperature is lower than 300°C, the recovery of the elongation, the bending property, and the spring limit value becomes insufficient. When the substantial temperature is higher than 600°C, it results in lowering of the strength.

Further, the electrical/electronic part of the present invention can be obtained by appropriately working the copper alloy material for electrical/electronic equipments. This working method is not particularly limited, and the part may be fabricated into a desired part shape in a usual manner, for example, by plastic working, such as press working.

### EXAMPLES

The present invention will be described in more detail based on examples given below, but the invention is not meant to be limited by these.

### Example 1

Copper alloys having compositions shown in Table 1, were melt, followed by casting into ingots with thickness 30 mm, width 100 mm, and length 150 mm, by the DC method, respectively. Then, the ingots were heated to 900°C, to maintain at this temperature for 1 hour, followed by hot rolling to thickness 12 mm, and cooling immediately thereafter. Then, the oxide film layer was removed by face-milling the respective face in 1.5 mm for each, followed by dough rolling to thickness 0.25 to 0.50 mm. Then, the resultant sheets were subjected to a solution treatment under any of conditions at 750°C to 880°C, followed, immediately thereafter, by cooling with a cooling speed of 15°C/sec or more. Then, the resultant sheets were subjected to intermediate rolling with rolling ratio 5 to 50%. Then, the resultant sheets were subjected to aging at 450 to 550°C for 2 hours in an inert gas atmosphere, followed by finish rolling with rolling ratio 30% or less, to adjust the final sheet thickness to 0.20 mm. After the finish rolling, the sheets were subjected to a low-temperature annealing at 500°C for 30 seconds, and the thus-obtained materials were utilized to conduct the following various property evaluations. Herein, the unit for elements of the copper alloy (Ni, Si, and the like) indicated in the respective table is all percentage by mass (mass%), except for the value of Ni/Si (no unit) which is in terms of mass ratio.

Then, with respect to the copper alloy sheets produced in the above, investigation was carried out on (1) grain size, (2) tensile strength, (3) electrical conductivity, and (4) bending property. The results are shown in Table 1.
(1) The grain size was measured, according to JIS H 0501 (the cutting method).
(2) The tensile strength was measured with a No. 5 test piece as specified in JIS Z 2201, according to JIS Z 2241. The tensile strength was indicated as a value rounded off to an integer multiple of 5 MPa.
(3) The electrical conductivity was measured, according to JIS H 0505.
(4) The bending property was defined as R/t, which was a ratio of the minimum bending radius (R) at which no cracks occurred and the sheet thickness (t), with a bending test piece with width w of 2 mm and sheet thickness t of 0.20 mm, in a 180°-bending test conducted with bending radius R (mm) of 0 to 0.6. When cracks occurred even at R/t of 3.0, the result was indicated as R/t > 3. The evaluation of the bent portion was carried out, according to the Japan Brass Makers Association, Technical Standard, "Evaluation on Bending Property of Thin Sheet and Strip of Copper and Copper Alloys" (JBMA T307:1999).

{Table 1}

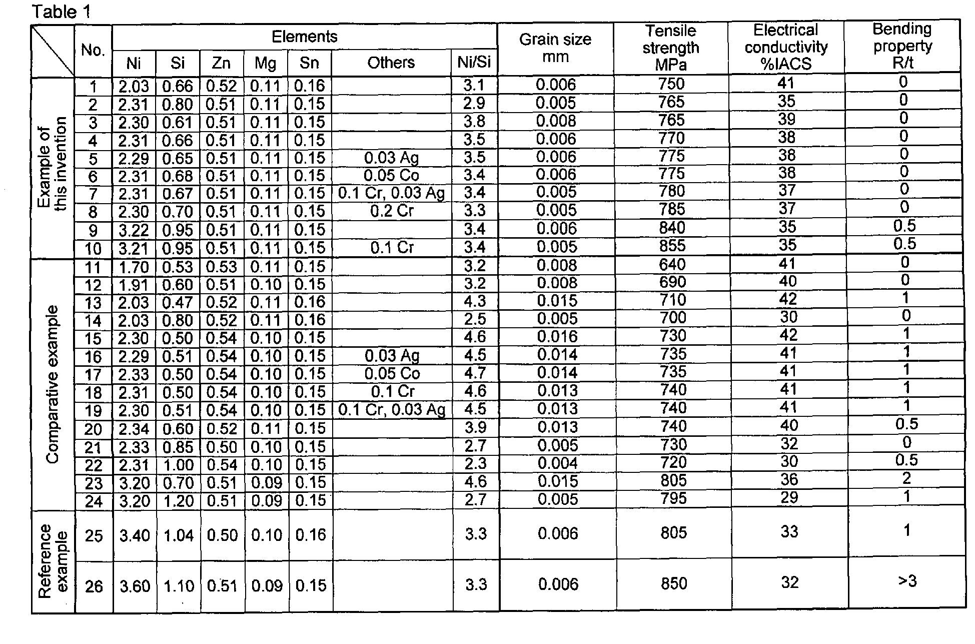

As shown in Table 1, Examples 1 to 10 according to the present invention exhibited excellent characteristics in both of a high tensile strength and an excellent bending property. Examples 1 to 10 according to the present invention each had an electrical conductivity of 35% IACS or higher, a tensile strength of 750 MPa or higher, and the bending property in the value of R/t of 0 to 0.5.
Comparative examples 11 and 12 had the Ni/Si within the defined range, but since the amount of Ni was less than the lower limit value, the strength was insufficient. Comparative examples 13, 15 to 20, and 23, which had the ratios Ni/Si greater than the upper limit value, were lower in the mechanical strength, as compared with those of the examples according to the present invention having the corresponding compositions, respectively. Furthermore, since these comparative examples were large in the grain size, they were poor in the bending property. Comparative examples 14, 21, 22, and 24, which had the ratios Ni/Si less than the lower limit value, were lower in the mechanical strength, as compared with those of the examples according to the present invention having the corresponding compositions, respectively, and furthermore these comparative examples were also poor in the electrical conductivity. Comparative example 24 was also poor in the bending property. Reference examples 25 and 26 had larger amounts of Ni compared to the defined range, and thus they failed to obtain such the remarkably favorable bending property as in the examples according to the present invention.

### Example 2

Using the ingots of Nos. 4, 15, and 22, as produced in the above Example 1, the results are shown in Table 2, in which investigations were made on the effects of changing the post-solution treatment steps. The numbers shown in Table 2 are indicated such that, for example, when the production process was modified using the ingot No. 4, the instance is indicated with a sub-number such as 4-2.
Example 4-2 according to the present invention, and Comparative examples 15-2 and 22-2 were produced, in the same production process as described in the above Example 1, except for changing the aging to a two-stage aging treatment to conduct aging at 350°C for 2 hours and then aging at 500°C for 2 hours. Example 4-3 according to the present invention, and Comparative examples 15-3 and 22-3 were produced, in the same production process as described in the above Example 1, except for not conducting the intermediate rolling immediately before the aging treatment, and changing the aging to a two-stage aging treatment to conduct aging at 350°C for 2 hours and then aging at 500°C for 2 hours. Reference example 4-4 was a test example in which the same production process as described in the above Example 1 was carried out, except for not conducting the intermediate rolling immediately before the aging treatment, and changing the aging to a single stage aging treatment at 500°C for 2 hours, which is a comparative example with respect to the invention according to the item (3) above.
The investigation on the properties was carried out, with respect to the copper alloy sheets, in the same manner as in the above Example 1, on (1) grain size, (2) tensile strength, (3) electrical conductivity, and (4) bending property. The results are shown in Table 2.

### {Table 2}

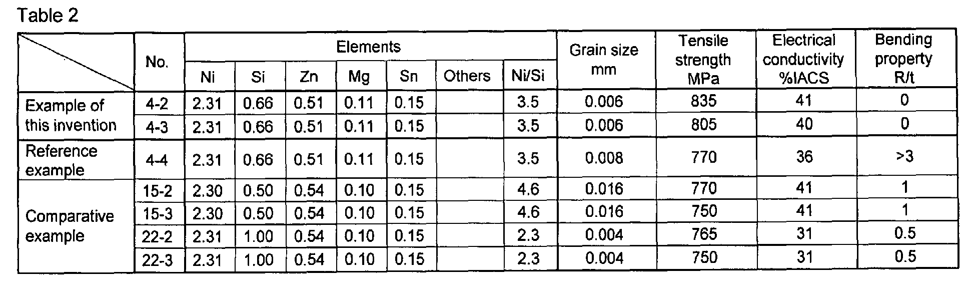

Examples 4-2 and 4-3 according to the present invention each had achieved a higher mechanical strength than Example No. 4 according to the present invention of the above Example 1, and an excellent bending property.
Contrary to the above, Comparative examples 15-2 and 15-3, which had the Ni/Si larger than the upper limit value, were lower in the mechanical strength with no effects of modifying the process, as compared to Examples 4-2 and 4-3 according to the present invention; and since they were larger in the grain size, they were poor in the bending property. Comparative examples 22-2 and 22-3, which had the Ni/Si less than the lower limit value, were low in the electrical conductivity, and low in the mechanical strength, as compared to Examples 4-2 and 4-3 according to the present invention with no effects of modifying the process. Further, Reference example 4-4, which was a test example in which the finish rolling ratio was increased so as to try to enhance the mechanical strength, but the resultant strength was rather lowered, and the bending property was poor.

### INDUSTRIAL APPLICABILITY

The copper alloy material for electrical/electronic equipments of the present invention has a high mechanical strength and is excellent in the bending property, and thus can be favorably used in parts for electrical/electronic equipments, particularly in spring contacts of connectors, and the like. Furthermore, since the electrical/electronic part of the present invention is one obtained by working the copper alloy material for electrical/electronic equipments, the part is favorable as a part for the use in connectors, where a remarkably favorable bending property is required, despite of having a high mechanical strength.

Having described our invention as related to the present embodiments, it is our intention that the invention not be limited by any of the details of the description, unless otherwise specified, but rather be construed broadly within its spirit and scope as set out in the accompanying claims.

This application claims priority on Patent Application No. 2008-092314 filed in Japan on March 31, 2008, which is entirely herein incorporated by reference.

## Claims

1. A copper alloy material for an electrical/electronic equipment, containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, and Zn 0.2 to 1.5 mass%, with the balance of Cu and inevitable impurities, wherein when a test piece with thickness t of 0.20 mm and width w of 2.0 mm is subjected to 180°-bending with bending radius R (mm), a value of the minimum bending radius R causing no cracks is 0 mm to 0.1 mm.

2. A copper alloy material for an electrical/electronic equipment, containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, Zn 0.2 to 1.5 mass%, and one or more selected from the group consisting of Ag, Co, and Cr in a sum total of 0.005 to 2.0 mass%, with the balance of Cu and inevitable impurities, wherein when a test piece with thickness t of 0.20 mm and width w of 2.0 mm is subjected to 180°-bending with bending radius R (mm), a value of the minimum bending radius R causing no cracks is 0 mm to 0.1 mm.

3. The copper alloy material for an electrical/electronic equipment according to claim 1 or 2, which is produced by subjecting a cast ingot to a hot rolling, a dough (cold) rolling, and a solution treatment, followed by an intermediate (cold) rolling with rolling ratio of 5 to 50%, an aging at 400 to 600°C for 0.5 to 12 hours, a finish (cold) rolling with rolling ratio of 30% or less, and a low-temperature annealing, in this order.

4. The copper alloy material for an electrical/electronic equipment according to claim 1 or 2, which is produced by subjecting a cast ingot to a hot rolling, a dough (cold) rolling, and a solution treatment, followed by an aging at 300 to 400°C for 0.5 to 8 hours, a further aging at 425 to 600°C for 0.5 to 12 hours, a finish (cold) rolling, and a low-temperature annealing, in this order.

5. The copper alloy material for an electrical/electronic equipment according to claim 1 or 2, which is produced by subjecting a cast ingot to a hot rolling, a dough (cold) rolling, and a solution treatment, followed by an intermediate (cold) rolling with rolling ratio of 5 to 50%, an aging at 300 to 400°C for 0.5 to 8 hours, a further aging at 425 to 600°C for 0.5 to 12 hours, a finish (cold) rolling with rolling ratio of 30% or less, and a low-temperature annealing, in this order.

6. An electrical/electronic part obtained by working a copper alloy material for an electrical/electronic equipment, with the copper alloy material containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, and Zn 0.2 to 1.5 mass%, with the balance of Cu and inevitable impurities, wherein when a test piece of the copper alloy material with thickness t of 0.20 mm and width w of 2.0 mm is subjected to 180°-bending with bending radius R (mm), a value of the minimum bending radius R causing no cracks is 0 mm to 0.1 mm.

7. An electrical/electronic part obtained by working a copper alloy material for an electrical/electronic equipment, with the copper alloy material containing Ni not less than 2.0 mass% and less than 3.3 mass%, having a content of Si within the range of 2.8 to 3.8 in terms of a mass ratio of Ni and Si (Ni/Si), and containing Mg 0.01 to 0.2 mass%, Sn 0.05 to 1.5 mass%, Zn 0.2 to 1.5 mass%, and one or more selected from the group consisting of Ag, Co, and Cr in a sum total of 0.005 to 2.0 mass%, with the balance of Cu and inevitable impurities, wherein when a test piece of the copper alloy material with thickness t of 0.20 mm and width w of 2.0 mm is subjected to 180°-bending with bending radius R (mm), a value of the minimum bending radius R causing no cracks is 0 mm to 0.1 mm.
